# EUROPEAN PATENT SPECIFICATION

(11) **EP 0 956 644 B1**
(45) Date of publication and mention of the grant of the patent: **10.05.2006**
(21) Application number: 98901032.7
(22) Date of filing: 29.01.1998
(51) Int. Cl.: H03J 7/26, H03L 7/12, H04L 27/227

(54) **AUTOMATIC FREQUENCY CONTROL CIRCUIT**
AUTOMATISCHE FREQUENZREGELUNGSSCHALTUNG
CIRCUIT DE REGLAGE AUTOMATIQUE DE FREQUENCE

(30) Priority: 30.01.1997 JP 2981197
(43) Date of publication of application: 17.11.1999
(73) Proprietor: Kabushiki Kaisha Kenwood, Shibuya-ku, Tokyo 150-0043 (JP)
(72) Inventor: HORII, Akihiro, Zama-shi, Kanagawa 228 (JP); SHIRAISHI, Kenichi, Yokohama-shi, Kanagawa 240 (JP)
(74) Representative: Leinweber & Zimmermann
(86) International application number: PCT/JP1998/000354
(87) International publication number: WO 1998/034347

(56) References cited:
- EP-A- 0 445 522
- US-A- 4 281 412
- US-A- 4 833 416
- US-A- 5 289 506
- US-A- 5 563 537

## Description

### BACKGROUND OF THE INVENTION

### 1. Field of the Invention

The present invention relates to an automatic frequency control circuit to be used by a satellite broadcast receiver of a digital modulation type, and more particularly to an automatic requency control circuit for scanning a demodulation carrier frequency in a predetermined width.

### 2. Description of.the Related Art

In this specification, a term "scanning" means frequency scanning for the regeneration of a demodulation carrier, and the term "scanning frequency width" means a range of central frequency change of a received signal which range is to be covered by a broadcast receiver. For example, a presently used CS digital satellite broadcast receiver has a scanning frequency width of about +/- 1.5 MHz.

After the power of a receiver of this type is turned on, scanning is performed. If a frame sync signal is received during this scanning, it is judged that the reception is in a frame sync state, and the scanning is stopped and a tracking state enters.

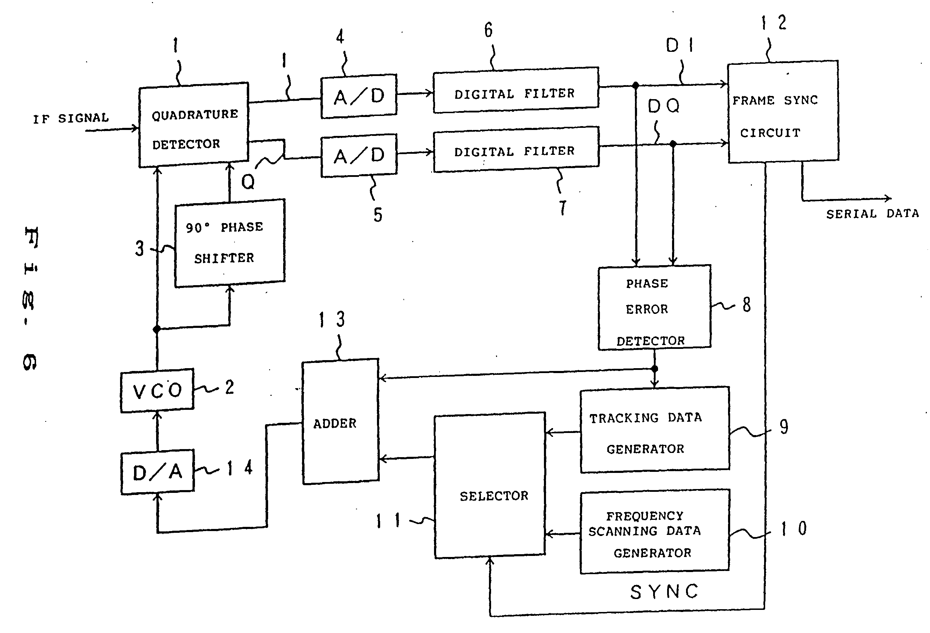

The structure of a receiver including a conventional automatic frequency control (hereinafter abbreviated as AFC where applicable) circuit as disclosed in U.S. Patent No.4,281,412 is partially shown in Fig. 6. The conventional AFC circuit will be described with reference to the receiver shown in Fig. 6. A received wave which was phase-shift keyed is converted into a predetermined frequency and input to a quadrature detector 1. The quadrature detector 1 is supplied with an oscillation output or demodulation carrier from a voltage controlled oscillator (hereinafter abbreviated as VCO) and an output or 90° shifted oscillation output from a 90° phase shifter 3. The frequency converted signal input to the quadrature detector 1 is therefore converted into I-and Q axes baseband signals.

The baseband signals are supplied to respective A/D converters 4 and 5 which convert them into discrete digital signals. The discrete digital signals are passed through respective digital filters 6 and 7 which output band-limited baseband signal DI and DQ. These baseband signals DI and DQ are supplied to a phase error detector 8 and to a frame synch circuit 12. The frame sync circuit 12 outputs serial data of the baseband signals DI and DQ and also outputs, when a frame synchronization is established, a high level frame sync signal (hereinafter abbreviated as SYNC signal where applicable).

The SYNC signal takes a high level when a frame synchronization is established. It is judged that the frame synchronization is established if a reception of a sync pattern at a constant period is detected at the head i of frame data contained in a series of received data.

A frequency scanning data generator 10 generates scanning data which scans the oscillation frequency of VCO 2 in a scanning frequency width.

A phase error detector 8 detects a phase error in accordance with the input baseband signals DI and DQ. Phase error data representative of the detected phase error is supplied to a tracking data generator 9, which data is used as tuning data for VCO 2. The tracking data generator 9 generates tracking data in accordance with the supplied phase error data.

A selector 11 is supplied with the tracking data from the tracking data generator 9 and the scanning data from the frequency scanning data generator 10. If SYNC is a low level, i.e., if the frame synchronization is not established, the scanning data is selected by the selector 11, whereas if SYNC is a high level, i.e., if the frame synchronization is established, the tracking data is selected by the selector 11.

The data output from the selector 11 and the tuning data are added together by an adder 13, and the output of the adder 13 is converted by a D/A converter 14 into an analog signal which controls the oscillation frequency of VCO 2. Namely, if the frame synchronization is not established, an addition signal of the scanning data selected by the selector 11 and the tuning data controls the oscillation frequency of VCO 2 to thereby carry out scanning.

If the frame synchronization is established during the scanning, an addition signal of the tracking data selected by the selector 11 and the tuning data controls the oscillation frequency of VCO 2 to thereby carry out tracking.

In the conventional AFC circuit, the frequency scanning data generator 10 is set with a scanning step frequency width in accordance with a capture range under the reception lowest conditions, e.g., at a reception limit ratio of carrier to noise (this ratio of carrier to noise is hereinafter abbreviated as C/N ratio, where applicable). It is therefore necessary to repeat the scanning (scanning frequency width)/(scanning step frequency width) times in order to scan the whole of the scanning frequency width.

In this specification, the term "scanning step frequency width" means a frequency change width per one scanning while the whole of the scanning frequency width is scanned.

In the above-described conventional AFC circuit, the scanning step frequency width for scanning the frequency of the demodulation carrier is narrower than the capture range used for the reproduction of the demodulation carrier, and in addition it is generally set to a value corresponding to a capture range determined from the reception limit C/N ratio. This poses the problem that it takes a constant scanning time to scan the whole of the scanning step frequency width, irrespective of a C/N ratio at that time.

It is an object of the present invention to provide an automatic requency control circuit capable of receiving a desired signal in a shortest scanning time corresponding to a current reception C/N ratio.

### SUMMARY OF THE INVENTION

The above object is achieved by an automatic frequency control circuit as defined in claim 1. According to one aspect of the present invention, an frequency control circuit is provided which comprises: reception C/N ratio judging means for judging a reception C/N ratio in accordance with signal point positions of a received and detected phase shift keying signal; scanning step frequency width converting means for converting the reception C/N ratio judged by the reception C/N ratio judging means into a predetermined scanning step frequency width preset for the reception C/N ratio; and voltage converting means for converting the converted scanning step frequency width into a scanning voltage, wherein the converted scanning voltage is supplied to a voltage controlled oscillator as a frequency control voltage, an oscillation output of the voltage controlled oscillator being used as a demodulation carrier.

According to the automatic frequency control circuit of this invention, reception C/N ratio judging means judges a reception C/N ratio in accordance with signal point positions of a received and detected phase shift keying signal, scanning step frequency width converting means converts the reception C/N ratio judged by the reception C/N ratio judging means into a predetermined scanning step frequency width preset for the reception C/N ratio, and voltage converting means converts the converted scanning step frequency width into a scanning voltage, wherein the converted scanning voltage is supplied to the voltage controlled oscillator as a frequency control voltage to sequentially scanning the scanning frequency width, and an oscillation output of the voltage controlled oscillator is sent as a demodulation carrier.

It is possible, for example, to use a broad scanning step frequency width if the reception C/N ratio is high. By changing the scanning step frequency width with the reception C/N ratio, it becomes possible to shorten a time required for receiving a desired signal.

### BRIEF DESCRIPTION OF THE DRAWINGS

Fig. 1 is a block diagram partially showing the structure of a receiver including an AFC circuit according to an embodiment of the invention.
Fig. 2 is a timing chart illustrating the operation of the AFC circuit of the embodiment.
Fig. 3 is a flow chart illustrating the operation of the AFC circuit of the embodiment.
Fig. 4 is a flow chart illustrating the detailed operation of Step S12 shown in the flow chart of Fig. 3.
Fig. 5 is an illustrative diagram showing the relationship among a reception C/N ratio, a receiver capture range, a scanning step frequency width and a Vt counter step number, respectively of the AFC circuit of the embodiment.
Fig. 6 is a block diagram partially showing the structure of a receiver including a conventional AFC circuit.

### DETAILED DESCRIPTION OF THE PREFERRED EMBODIMENT

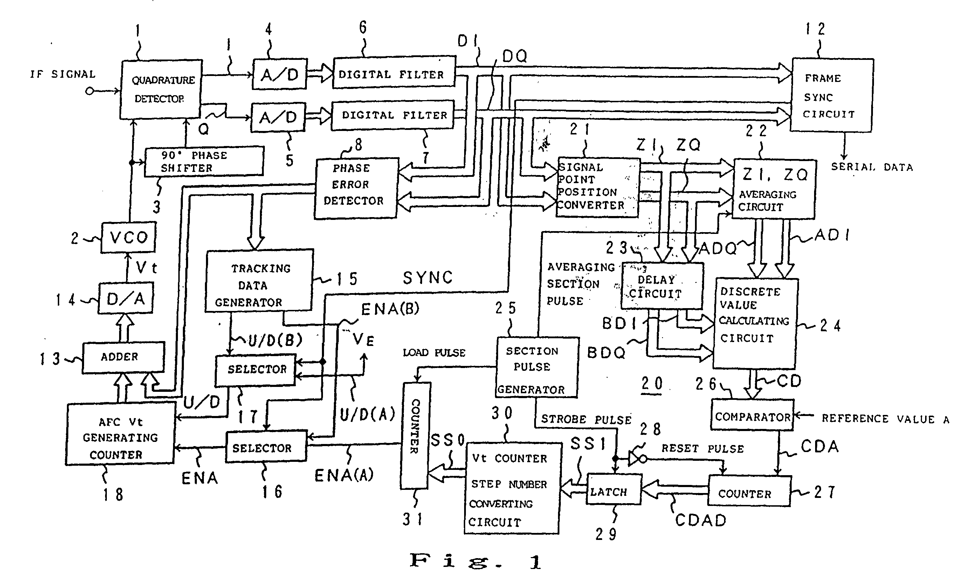

An embodiment of an automatic frequency control circuit of this invention will be described. Fig. 1 is a block diagram partially showing a receiver including the automatic requency control circuit of the embodiment. In this embodiment, QPSK modulation is illustratively used as phase modulation. In Fig. 1, like elements to those of the conventional automatic frequency control circuit shown in Fig. 6 are represented by using identical reference numerals.

Also in this receiver including the automatic frequency control circuit of this embodiment, after the power of the receiver is turned on, scanning is performed. If a frame sync signal is received during this scanning, it is judged that the reception is in a frame sync state, and the scanning is stopped and a tracking state enters.

In the automatic frequency control circuit of the embodiment, a received wave which was phase-shift keyed is converted into a predetermined frequency and input to a quadrature detector 1. The quadrature detector 1 is supplied with an oscillation output or demodulation carrier from a VCO 2 and an output or 90° shifted oscillation output from a 90 phase shifter 3. The frequency converted signal input to the quadrature detector 1 is therefore orthogonally detected to convert it into I- and Q axes baseband signals.

The baseband signals are supplied to respective A/D converters 4 and 5 which convert them into discrete digital signals. The discrete digital signals are passed through respective digital filters 6 and 7 which output band-limited baseband signals DI and DQ. These baseband signals DI and DQ are supplied to a phase error detector 8 and also to a frame sync circuit 12 which in turn outputs serial data of the baseband signals DI and DQ and also outputs a SYNC signal when a frame synchronization is established.

Frequency scanning by the automatic frequency control circuit of this embodiment will be described first. In the frequency scanning by the auto frequency control circuit of this embodiment, a C/N ratio is calculated and the frequency scanning step is controlled in accordance with the calculated C/N ratio.

The baseband signals DI and DQ whose band widths were limited by the digital filters 6 and 7 are supplied to a C/N ratio calculating block 20 which determines a C/N ratio.

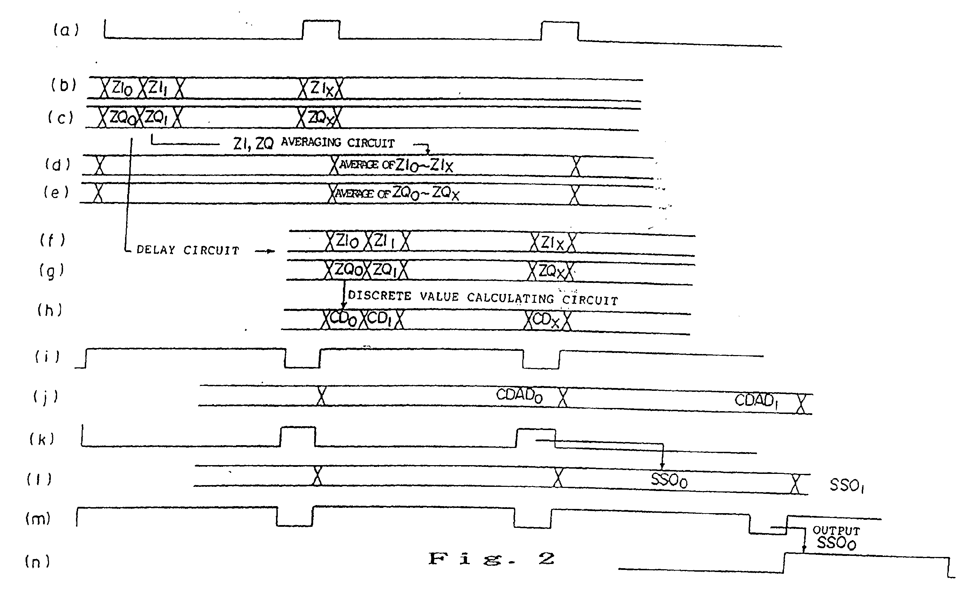

The C/N ratio calculating block 20 is constituted of a signal point position converting table 21, an averaging circuit 22, a delay circuit 23 and a discrete value calculating circuit 24. The signal point position converting table 21 is used for obtaining signal point position data ZI and ZQ by referring to the input baseband signals DI and DQ. The averaging circuit 22 is used for calculating average data ADI and ADQ during a predetermined period determined by an averaging section pulse shown in Fig. 2 at (a) and supplied from a section pulse generator 25, in accordance with the signal point position data ZI and ZQ obtained by the signal point position converting table 21. The delay circuit 23 is used for obtaining delay data BDI and BDQ by delaying the signal point position data ZI and ZQ obtained by the signal point position converting table 21, by a time required for averaging calculation. The discrete value calculating circuit 24 is used for obtaining discrete signal point positions in accordance with the average data ADI and ADQ and the delay data BDI and BDQ.

The signal point position converting table 21 will be described. In the case of QPSK modulation, a received signal (DI, DQ) has reference positions (0, 0), (0, 1), (1, 1) and (1, 0). The reference position (0, 0) is made to correspond to a first quadrant, (0, 1) is made to correspond to a second quadrant, the reference position (1, 1) is made to correspond to a third quadrant, and the reference position (1, 0) is made to correspond to a fourth quadrant. The reference position (0, 1) is rotated by 90° in the clockwise direction, the reference position (1, 1) is rotated by 180° in the clockwise direction, and the reference position (1, 0) is rotated by 90° in the counterclockwise direction to make the reference positions correspond to the first quadrant. The received signal (DI, DQ) related to the first quadrant is converted into the signal point position data. In this manner, the signal point converting table 21 can be simplified.

In the C/N ratio calculating block 20, the input baseband signals DI and DQ are converted into signal point position data ZI₀, ZI₂,..., ZIₓ and ZQ₀, ZQ₂, ..., ZQₓ as shown in Fig. 2 at (b) and (c) by the signal point position converting table 21. The converted signal point position data ZI₀, ZI₂,..., ZIₓ and ZQ₀, ZQ₂, ..., ZQₓ is supplied to the averaging circuit 22 which obtains an average ADI of ZI₀, ZI₂,..., ZIₓ and an average ADQ of ZQ₀, ZQ₂,..., ZQₓ during the period determined by the averaging section pulse, as shown in Fig. 2 at (d) and (e).

The signal point position data ZI₀, ZI₂,..., ZIₓ and ZQ₀, ZQ₂,..., ZQₓ converted by the signal point position converting table 21 is delayed by the delay circuit 23 by the period required for the averaging calculation by the averaging circuit 22, to thereby obtain delay data BDI and BDQ as shown in Fig. 2 at (f) and (g). Discrete data CD such as shown in Fig. 2 at (h) is obtained in accordance with the average data ADI and ADQ obtained by the averaging circuit 22 and the delay data BDI and BDQ delayed by the delay circuit 23.

The discrete data CD may be obtained by the calculation described above, or may be obtained by searching the discrete data CD from a discrete data table which stores the average data ADI and ADQ and the delay data BDI and BDQ and the corresponding discrete data, by using the average data ADI and ADQ and the delay data BDI and BDQ as a search key.

The discrete data CD obtained by the discrete value calculating circuit 24 is supplied to a comparator 26 to compare it with a reference value A. If the discrete data has the value A or larger, a high level signal CDA is output from the comparator 26 and supplied to a counter 27. Therefore, while the high level signal CDA indicating that the discrete data CD has the value A or larger, is output, the counter 27 counts a clock pulse.

The counter 27 is reset by a reset pulse shown Fig. 2 at (i), the reset pulse being the averaging section pulse inverted by an inverter 28. The counter 27 once reset resumes its operation of counting the clock pulse and continues the counting while the high level signal CDA indicating that the discrete data CD has the value A or larger, is output.

The reference value A is set, for example, to "1000". Therefore, a count CDAD of the counter 27 corresponds to the number of discrete data CDA equal to "1000" or larger. In other words, the count CDAD corresponds to the total number of discrete data equal to "1000" or larger during the period preset by the section pulse generator 25.

As shown in Fig. 2 at (j), the counter 27 outputs counts CDAD₀, CDAD₁,... during respective averaging section pulse periods. The count CDAD of the counter 27 is supplied to a latch circuit 29 and latched in response to a strobe pulse shown in Fig. 2 at (k) having the same period as the averaging section pulse period.

The count CDAD latched by the latch circuit 29 is the total number of discrete data equal to the reference value A or larger during the period preset by the section pulse generator 25, and is proportional to a reception C/N ratio which is independent from the carrier reproduction. Therefore, the reception C/N ratio can be detected through table conversion or the like.

The count CDAD latched by the latch circuit 29 is supplied as data SS1 to a Vt counter step number converting circuit 30 which in turn converts the supplied data SS1 into a Vt counter step number SS0 at the timing shown in Fig. 2 at (1). For example, the Vt counter step number converting circuit 30 has a table which stores Vt counter step numbers SS0 and corresponding data SS1, and searches the Vt counter step number SS0 corresponding to the supplied data SS1 from the table by using the data SS1 as a search key.

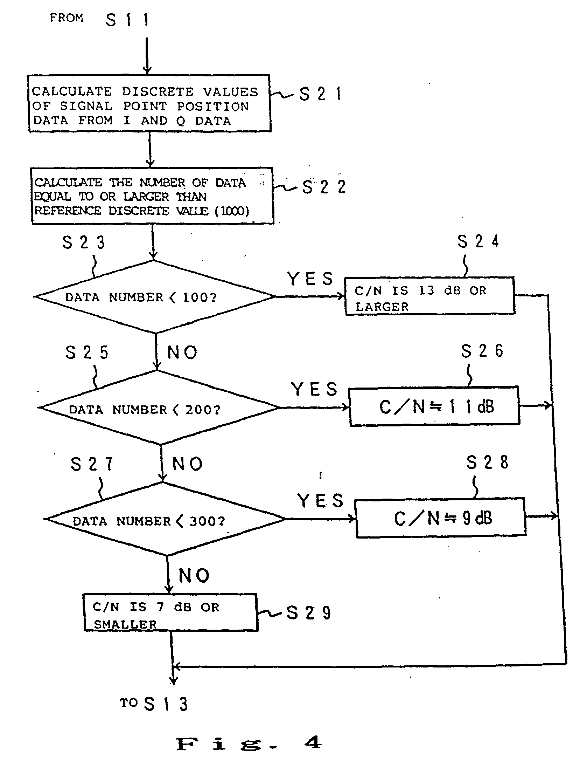

Next, the relationship between a discrete value and a C/N ratio will be described. As shown in Fig. 4, in the C/N ratio calculating block 20, discrete values of the signal point position data are calculated from the baseband signals DI and DQ (Step S21), the total number of discrete data equal to or larger than the reference value A ("1000") is counted by the counter 27 and latched by the latch circuit 29 (Step S22), and it is checked whether the total number is smaller than "100". If smaller than "100", it is determined that the reception C/N ratio is 13 dB or larger (Step S24).

If it is judged at Step S23 that the total number is not smaller than "100", it is checked whether the total number is smaller than "200" (Step S25). If the total number is "100" or larger, and smaller than "200", it is determined that the reception C/N ratio is about 11 dB (Step S26).

If it is judged at Step S25 that the total number is not smaller than "200", it is checked whether the total number is smaller than "300" (Step S27). If the total number is "200" or larger, and smaller than "300", it is determined that the reception C/N ratio is about 9 dB (Step S28). If it is judged at Step S27 that the total number is not smaller than "300", it is determined that the reception C/N ratio is about 7 dB or smaller (Step S29).

As above, it is judged that the reception C/N ratio is 13 dB or larger if the total number is smaller than "100", that the reception ratio is about 11 dB if the total number is smaller than "200", that the reception C/N ratio is about 9 dB if the total number is equal to or larger than "200" and smaller than "300", and that the reception C/N ratio is equal to or smaller than 7 dB if the total number is equal to or larger than "300". The total number of discrete data for determining the reception C/N ratio described above was obtained from experiments, and it may change with modulation method and system used.

Optimizing the scanning in accordance with the reception C/N ratio obtained in the above manner will be described.

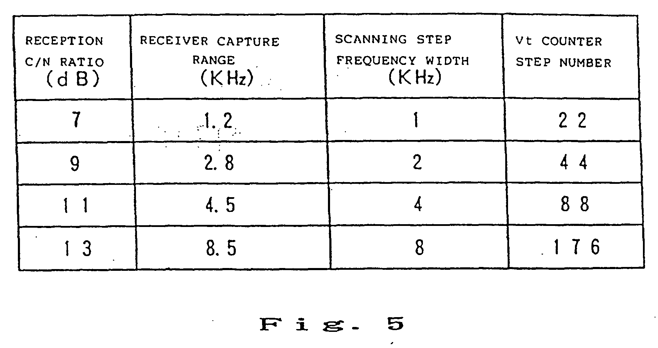

Fig. 5 shows the relationship between the reception C/N ratio judged in the above manner and the scanning step frequency width. In this relationship, the scanning step frequency width is set which satisfies the conditions that the capture range of a receiver actually measured is larger than the scanning step frequency width.

As described earlier, the scanning step frequency width is a frequency width to be changed at each scanning for scanning the whole of the scanning frequency width, and corresponds to the frequency width of the reproduction carrier output from VCO 2 during each scanning. If the tuning data supplied from the adder 13 does not change and is constant, the scanning step frequency width corresponds to a change in an output AFCCONT of an AFC Vt generating counter 18.

Therefore, if a change in the frequency of VCO 2 to be changed by one LSB bit supplied to the D/A converter 14 is represented by D, the scanning step frequency width is given by "D x (the output AFCCONT of the AFC Vt generating counter 18)".

In order to perform scanning at the scanning step frequency width corresponding to the reception C/N ratio, the AFC Vt generating counter 18 is therefore incremented by an amount of "(scanning step frequency width)/D" which is hereinunder called a Vt counter step number. In the AFC circuit of this embodiment, D is set to 45 Hz. As shown in Fig. 5, the Vt counter step numbers are set to 22, 44, 88 and 178 respectively at the reception C/N ratios of 7 dB, 9 dB, 11 dB and 13 dB.

The Vt counter step numbers were set to the above values because the Vt counter step number "22" x 45 Hz = 990 Hz is nearly equal to the scanning step frequency width of 1 kHz, the Vt counter step number "44" x 45 Hz = 1980 Hz is nearly equal to the scanning step frequency width of 2 kHz, the Vt counter step number "88" x 45 Hz = 3960 Hz is nearly equal to the scanning step frequency width of 4 kHz, and the Vt counter step number "178" x 45 Hz = 7920 Hz is nearly equal to the scanning step frequency width of 8 kHz.

Assuming that the reception center frequency change is +/- 1.5 MHz and so the scanning frequency width is 3 MHz, the whole scanning frequency width can be covered by the scanning step numbers of 3000, 1500, 750, and 375 respectively at the scanning step frequency widths of 1 kHz, 2 kHz, 4 kHz, and 8 kHz.

With the above settings, the scanning step frequency width is made narrower at the low reception C/N ratio, i.e., at a poor reception C/N ratio, because the capture range of the receiver is narrow and the reception signal cannot be captured, whereas the scanning step frequency width is made broader at the high reception C/N ratio, i.e., at a good reception C/N ratio, because the capture range of the receiver is broad and the reception signal can be captured.

With a conventional AFC circuit, the reception C/N ratio is not judged and the frequency scanning data is made i constant to suffice for the worst reception C/N ratio. In contrast, with the AFC circuit of this embodiment, the scanning step frequency width is changed with the reception C/N ratio in such a manner that the scanning step frequency width is made broader as the reception C/N ratio becomes higher.

The Vt counter step number converting circuit 30 refers to the supplied data SS1 and searches the Vt counter step number SS0 from the table which stores Vt counter step numbers SS0. The searched Vt counter step number SS0 is output to a counter 31 at a timing shown in Fig. 2 at (1).

The Vt counter step number SS0 is loaded in the counter 31 in response to a load pulse shown in Fig. 2 at (m) and output from the section pulse generator 25, and thereafter the counter 31 counts a clock pulse. The counter 31 outputs scanning data ENA (A) of a high level to a selector 16 until the count of the counter 31 reaches the Vt counter step number SS0.

A selector 17 is supplied with an up/down (U/D) (A) signal pulled up to the high level. During the scanning mode, i.e., while frame synchronization is not established, a SYNC signal supplied to the selectors 16 and 17 has a low level so that the selectors 16 and 17 select the scanning data ENA (A) and U/D (A) data and supply them to an AFC Vt generating counter 18.

The AFC Vt generating counter 18 counts up the clock pulse in a direction of scanning to a higher frequency, in response to the U/D (A) signal, while the scanning data ENA (A) is supplied. The count of the AFC Vt generating counter 18 and tuning data supplied from the phase error detector 8 are added together by an adder 13. Output data of the adder 13 is converted into an analog signal by a D/A converter 14. This analog signal is supplied to VCO 2 as a frequency control voltage to thereby control the oscillation frequency of VCO 2.

The U/D (A) signal may be pulled down to the low level. In this case, the AFC Vt generating counter 18 counts down the clock pulse in a direction of scanning to a lower frequency.

The frequency of a demodulation carrier reproduced as above is controlled by a frequency control voltage Vt supplied to VCO 2. This frequency control voltage of VCO 2 is output from the D/A converter 14. The relationship between addition data Vtd output from the adder 13 and input to the D/A converter 14 and the frequency of the reproduced demodulation carrier is made linear.

For example, if the Vt counter step number shown in Fig. 5 is set to "22", the frequency of the reproduced demodulation carrier can take an offset of +/- 1 kHz by incrementing or decrementing the data corresponding to "22" at the adder 13. As above, the scanning step number can be changed and optimized in accordance with the judged C/N ratio. If frame synchronization is established during the scanning, the SYNC signal takes the high level, At the; same time when the SYNC signal takes the high level, the scanning state is switched to the tracking state.

The phase error detector 8 is structured, for example, by a Costas operation circuit calculator having a conversion table. The phase error detector 8 calculates [(DI + DQ)·(DI - DQ)·DI·DQ] to detect a position error, i.e., phase error data, of the reception signal point positions of input baseband signals DI and DQ from the reference positions, for each quadrant. This phase error data is supplied to the adder 13 as the tuning data. A Costas loop for the reproduction of a basic demodulation carrier can therefore be formed, the loop being VCO 2 and 90° phase shifter 3 → quadrature detector 1 → A/D converter 4, 5 → digital filter 6, 7 → phase error detector 8 → adder → D/A converter 14 → VCO 2.

The phase error data is supplied to a tracking data generator 15 which generates tracking data. For example, the tracking data generator 15 has an averaging circuit and a comparator. The averaging circuit receives the phase error data and calculates an average value during a predetermined period, and the comparator compares the average value calculated by the averaging circuit with predetermined values on both sides of the center value (a value 0 in Costas operation) of Costas data, to check whether the average value is in the range between the predetermined values. If the average value is not in the range between the predetermined values, tracking data ENA (B) representative of a difference between the average value and one of the predetermined values is supplied to the selector 16 and an U/D (B) signal representative of the polarity of a difference between the average value and one of the predetermined values is supplied to the selector 17.

The selectors 16 and 17 are also supplied with the SYNC signal. If the SYNC signal is at the high level, the selector 16 selects the tracking data ENA (B) and the selector 17 selects the U/D (B) signal. The selected tracking data ENR (B) and U/D (B) signal are supplied to the AFC Vt generating counter 18 which counts up or down the tracking data ENA (B) in accordance with the U/D (B) signal.

The count of the AFC Vt generating counter 18 and the tuning data supplied from the phase error detector 8 are added together by the adder 13. The output data of the adder 13 is converted by the D/A converter 14 into an analog signal which is supplied to VCO 2 as the frequency control voltage to thereby control the oscillation frequency of VCO 2.

As above, if the tracking data generator 15 judges that the average value is in the range between the predetermined values and the frame synchronization is established, the frequency offset is finely adjusted by the tuning data. On the other hand, if the average value is not in the range between the predetermined values and the frame synchronization is not established, the frequency offset is finely adjusted by a sum of the tuning data and tracking data.

As described above, in the AFC circuit of this embodiment, the tuning data supplied to VCO 2 in the midst of the Costas loop for the regeneration of the demodulation carrier is updated by the scanning data if the frame synchronization is not established, whereas if the frame synchronization is established, the fine adjustment is performed by using the tracking data.

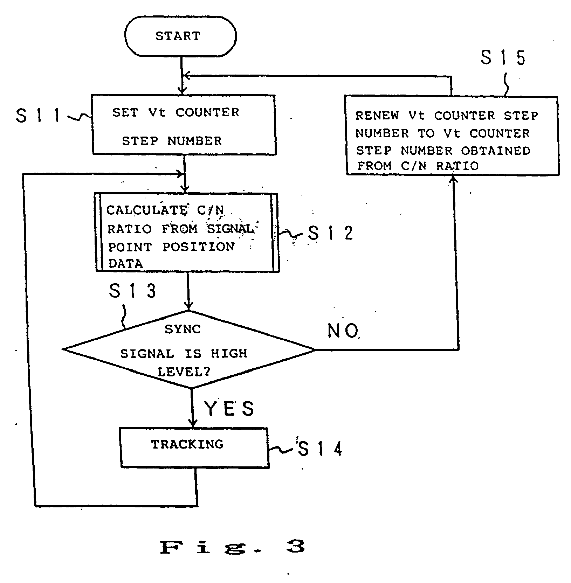

AFC control and tracking control will be described with reference to the flow chart shown in Fig. 3. If the SYNC signal is at the low level, i.e., if the frame synchronization is not established, the AFC circuit is in the scanning mode. In this mode, the Vt counter step number output from the Vt counter step number converting circuit 30 is loaded in the counter 31 which generates the scanning data ENA (A) having a time duration required for counting the clock pulses up to the Vt counter step number. The scanning data ENA (A) is supplied to the AFC Vt generating counter 18 which then counts up or down.

The scanning direction is selected by the U/D (A) signal. The data generated by the AFC Vt generating counter 18 is added to the tuning data by the adder 13, and the addition data is input to the D/A converter (Step S11). The above scanning operation is repeated (Steps S12, S13, S14 and S15) in accordance with the Vt counter step number satisfying the judged reception C/N ratio. The details of Step S12 are shown in the flow chart of Fig. 4. If a desired signal is received while Steps S12, S13, S14 and S15 are executed, the frame sync circuit 12 captures a sync signal contained in the received signal, and the data demodulation starts. At the same time, the SYNC signal takes the high level (Step S13).

When the SYNC signal takes the high level, the selectors 16 and 17 select the scanning data ENA (B) and U/D (B) signal to be replaced by the scanning data ENA (A) and U/D (A). The scanning operation is therefore stopped and the tracking operation starts in which the tracking data is added to the tuning data to finely adjust the frequency offset and repeat Steps starting from Step S12 (Step S14).

The scanning step frequency width of the AFC circuit depends on the capture range of the receiver. The capture range also changes with the reception C/N ratio. In a conventional AFC circuit, the scanning step frequency width is set in accordance with the capture range at the lowest target reception C/N ratio of the receiver so that it is set narrow irrespective of whether the reception C/N ratio is bad or good. Therefore, even at a good C/N ratio, the scanning is performed at a narrow scanning step frequency width and it takes a time to reproduce the demodulation carrier. In contrast, in the AFC circuit according to the embodiment of this invention, an optimum scanning step frequency width is selected in accordance with the judged reception C/N ratio. Accordingly, the capture range of the receiver is maintained properly and a desired signal can be received in a shortest scanning time corresponding to a current reception C/N ratio.

As described so far, according to the automatic frequency control circuit of this invention, a reception C/N ratio is judged by processing the I and Q signals detected by the receiver, and the scanning step frequency width is changed with the judged C/N ratio. Accordingly, it is possible to receive a desired signal in a shortest scanning time corresponding to a current reception C/N ratio.

## Claims

1. An automatic requency control circuit comprising:
means (1, 4, 6) for detecting a phase shift keying signal by using a demodulation carrier;
means (12) in response to the detected phase shift keying signal (DI, DQ) for generating a serial data and frame synchronization signal;
means (2, 13) for generating a scanning signal to scan the demodulation carrier by one scanning step frequency width and repeat said scanning over a predetermined scanning frequency band;
voltage converting means (14) for converting the scanning signal into a scanning voltage; and
means (8, 15-17) for stopping said scanning when the frame synchronization signal indicates a frame synchronized state and rendering said scanning means into a tracking mode;
wherein the converted scanning voltage is supplied to a voltage controlled oscillator (2) as a frequency control voltage, an oscillation output of the voltage controlled oscillator being used as the demodulation carrier
**CHARACTERIZED BY**
reception C/N ratio judging means (21-29) for judging a reception C/N ratio in accordance with signal point positions of the detected phase shift keying signal;
scanning step frequency width converting means (30-31) for converting the reception C/N ratio judged by said reception C/N ratio judging means into a predetermined scanning step frequency width.

2. An automatic frequency control circuit according to claim 1, wherein said reception C/N ratio judging means includes: signal point position converting means (21) for converting the received and detected phase shift keying signal into signal point position data; averaging means (22) for calculating an average value of the signal point position data; and discrete value calculating means (24) for calculating a discrete value in accordance with the average value calculated by said averaging means and the signal point position data, wherein the reception C/N ratio is judged from the discrete value calculated by said discrete value calculating means.

3. An automatic requency control circuit according to claim 2, wherein said reception C/N ratio judging means includes delaying means (23) for delaying the signal point position data converted by said signal point position converting means by a calculation time of said averaging means, wherein said discrete value calculating means calculates the discrete value in accordance with the average value calculated by said averaging means and the signal point position data delayed by said delaying means.

4. An automatic requency control circuit according to claim 2, wherein said reception C/N ratio judging means includes counting means (26, 27) for counting the number of occurrences of the discrete value equal to or larger than a predetermined reference value during a predetermined period, wherein the reception C/N ratio is judged from a count of said counting means.

5. An automatic frequency control circuit according to claim 1, wherein said scanning step frequency width converting means converts the reception C/N ratio into a broader scanning step frequency width as the reception C/N ratio is higher.

6. An automatic requency control circuit according to claim 1,
wherein said scanning step frequency width converting means includes storage means (30) for storing a scanning step frequency width corresponding to the judged reception C/N ratio, wherein the scanning step frequency width corresponding to the judged C/N ratio is read from said storage means by referring to the judged C/N ratio.

7. An automatic frequency control circuit according to claim 1, wherein said stopping means comprises switching means (16, 17) for switching the frequency control voltage supplied to the voltage controlled oscillator from the scanning voltage to a tracking voltage, when a frame sync signal is detected from a received signal.

## Patentansprüche

1. Automatische Frequenzsteuerschaltung umfassend:
eine Einrichtung (1, 4, 6) zur Erfassung eines Phasenumtastungssignals durch Verwendung eines Demodulationsträgers;
eine auf das erfasste Phasenumtastungssignal (DI, DQ) reagierende Einrichtung (12) zur Erzeugung serieller Daten und eines Rahmensynchronisationssignals;
eine Einrichtung (2, 13) zur Erzeugung eines Abtastsignals, um den Demodulationsträger mittels einer Abtastschrittfrequenzbreite abzutasten und um das Abtasten über ein vorgegebenes Abtastfrequenzband zu wiederholen;
eine Spannungswandlungseinrichtung (14) zur Wandlung des Abtastsignals in eine Abtastspannung; und
eine Einrichtung (8, 15-17), um das Abtasten zu stoppen, wenn das Rahmensynchronisationssignal einen synchronisierten Rahmenzustand angibt, und um die Abtasteinrichtung in einen Tracking-Modus zu bringen;
wobei die gewandelte Abtastspannung einem spannungsgesteuerten Oszillator (2) zugeführt wird als Frequenzsteuerspannung, wobei eine Oszillationsausgabe des spannungsgesteuerten Oszillators als der Demodulationsträger verwendet wird,
**GEKENNZEICHNET DURCH**
eine Empfangs-CNR-Beurteilungseinrichtung (21-29) zur Beurteilung eines Empfangs-CNR in Übereinstimmung mit Signalpunktpositionen des erfassten Phasenumtastungssignals;
eine Wandlungseinrichtung (30-31) für eine Abtastschrittfrequenzbreite zur Wandlung des durch die Empfangs-CNR-Beurteilungseinrichtung beurteilten Empfangs-CNR in eine vorgegebene Abtastschrittfrequenzbreite.

2. Automatische Frequenzsteuerschaltung nach Anspruch 1,
wobei die Empfangs-CNR-Beurteilungseinrichtung umfasst: eine Signalpunktpositionswandlungseinrichtung (21) zur Wandlung des empfangenen und erfassten Phasenumtastungssignals in Signalpunktpositionsdaten; eine Durchschnittsberechnungseinrichtung (22) zur Berechnung eines Durchschnittswerts der Signalpunktpositionsdaten; und eine Diskretwertberechnungseinrichtung (24) zur Berechnung eines diskreten Werts in Übereinstimmung mit dem von der Durchschnittsberechnungseinrichtung berechneten Durchschnittswert und den Signalpunktpositionsdaten, wobei das Empfangs-CNR beurteilt wird anhand des von der Diskretwertberechnungseinrichtung berechneten diskreten Werts.

3. Automatische Frequenzsteuerschaltung nach Anspruch 2,
wobei die Empfangs-CNR-Beurteilungseinrichtung eine Verzögerungseinrichtung (23) umfasst zur Verzögerung der von der Signalpunktpositionswandlungseinrichtung gewandelten Signalpunktpositionsdaten um eine Berechnungszeit der Durchschnittsberechnungseinrichtung, wobei die Diskretwertberechnungseinrichtung den diskreten Wert in Übereinstimmung mit dem von der Durchschnittsberechnungseinrichtung berechneten Durchschnittswert und den von der Verzögerungseinrichtung verzögerten Signalpunktpositionsdaten berechnet.

4. Automatische Frequenzsteuerschaltung nach Anspruch 2,
wobei die Empfangs-CNR-Beurteilungseinrichtung eine Zähleinrichtung (26, 27) umfasst zur Zählung der Anzahl von Vorkommen des diskreten Werts gleich einem oder größer als ein vorgegebener/m Referenzwert während eines vorgegebenen Zeitraums, wobei das Empfangs-CNR anhand einer Zählung der Zähleinrichtung beurteilt wird.

5. Automatische Frequenzsteuerschaltung nach Anspruch 1,
wobei die Wandlungseinrichtung für die Abtastschrittfrequenzbreite das Empfangs-CNR in eine breitere Abtastschrittfrequenzbreite wandelt, während das Empfangs-CNR höher ist.

6. Automatische Frequenzsteuerschaltung nach Anspruch 1,
wobei die Wandlungseinrichtung für die Abtastschrittfrequenzbreite eine Speichereinrichtung (30) zur Speicherung einer Abtastschrittfrequenzbreite umfasst, welche dem beurteilten Empfangs-CNR entspricht, wobei die dem beurteilten CNR entsprechende Abtastschrittfrequenzbreite aus der Speichereinrichtung unter Bezugnahme auf das beurteilte CNR ausgelesen wird.

7. Automatische Frequenzsteuerschaltung nach Anspruch 1,
wobei die Stoppeinrichtung eine Schalteinrichtung (16, 17) umfasst zur Schaltung der Frequenzsteuerspannung, die dem spannungsgesteuerten Oszillator aus der Abtastspannung zugeführt wird, auf eine Tracking-Spannung, wenn ein Rahmensynchronisationssignal aus einem empfangenen Signal erfasst wird.

## Revendications

1. Circuit de réglage automatique de fréquence comprenant:
des moyens (1, 4, 6) pour détecter un signal de modulation par déplacement de phase en utilisant une porteuse de démodulation;
des moyens (12) pour, en réponse au signal de modulation par déplacement de phase détecté (DI, DQ), produire un signal de synchronisation de trame et de données en série;
des moyens (2, 13) pour produire un signal de balayage pour balayer la porteuse de démodulation par une largeur de fréquence d'une étape de balayage et répéter ledit balayage sur une bande de fréquences de balayage prédéterminée;
des moyens de conversion de tension (14) pour convertir le signal de balayage en une tension de balayage; et
des moyens (8, 15 à 17) pour faire cesser ledit balayage lorsque le signal de synchronisation de trame indique un état de trame synchronisée, et pour faire passer lesdits moyens de balayage dans un mode de suivi;
dans lequel la tension de balayage convertie est envoyée vers un oscillateur commandé en tension (2) sous la forme d'une tension de réglage de fréquence, une sortie d'oscillation de l'oscillateur commandé en tension étant utilisée pour servir de porteuse de démodulation,
**CARACTÉRISÉ PAR**
des moyens d'appréciation (21 à 29) d'un rapport C/N (Carrier to Noise (de porteuse sur bruit) en réception, pour apprécier un rapport C/N en réception en fonction de positions de point de signal du signal de modulation par déplacement de phase détecté;
des moyens de conversion (30 à 31) d'une largeur de fréquence d'une étape de balayage, pour convertir le rapport C/N en réception apprécié par lesdits moyens d'appréciation d'un rapport C/N en réception, en une largeur de fréquence d'une étape de balayage prédéterminée.

2. Circuit de réglage automatique de fréquence selon la revendication 1, dans lequel lesdits moyens d'appréciation d'un rapport C/N en réception comprennent: des moyens de conversion d'une position de point de signal (21), pour convertir le signal de modulation par déplacement de phase reçu et détecté, en des données de position de point de signal; des moyens de pondération (22), pour calculer une valeur moyenne des données de position de point de signal; et des moyens de calcul d'une valeur discrète (24) pour calculer une valeur discrète en fonction de la valeur moyenne calculée par lesdits moyens de pondération et des données de position de point de signal, dans lesquels le rapport C/N en réception est apprécié à partir de la valeur discrète calculée par lesdits moyens de calcul d'une valeur discrète.

3. Circuit de réglage automatique de fréquence selon la revendication 1, dans lequel lesdits moyens d'appréciation d'un rapport C/N en réception comprennent des moyens de retardement (23), pour retarder les données de position de point de signal converties par lesdits moyens de conversion d'une position de point de signal, d'une période de temps de calcul desdits moyens de pondération, dans lequel lesdits moyens de calcul d'une valeur discrète calculent la valeur discrète en fonction de la valeur moyenne calculée par lesdits moyens de pondération et des données de position de point de signal retardées par lesdits moyens de retardement.

4. Circuit de réglage automatique de fréquence selon la revendication 2 dans lequel lesdits moyens d'appréciation d'un rapport C/N en réception comprennent des moyens de comptage (26, 27), pour compter le nombre de fois où la valeur discrète est égale ou supérieure à une valeur de référence prédéterminée au cours d'une période de temps prédéterminée, dans lequel le rapport C/N en réception est apprécié à partir d'un comptage desdits moyens de comptage.

5. Circuit de réglage automatique de fréquence selon la revendication 1, dans lequel lesdits moyens de conversion d'une largeur de fréquence d'une étape de balayage convertissent le rapport C/N en réception en une largeur de fréquence d'une étape de balayage plus étendue à mesure que le rapport C/N en réception augmente.

6. Circuit de réglage automatique de fréquence selon la revendication 1, dans lequel lesdits moyens de conversion d'une largeur de fréquence d'une étape de balayage comprennent des moyens de stockage (30), pour stocker une largeur de fréquence d'une étape de balayage qui correspond au rapport C/N en réception apprécié, dans lequel la largeur de fréquence d'une étape de balayage qui correspond au rapport C/N en réception apprécié, est lue à partir desdits moyens de stockage en faisant référence au rapport C/N en réception apprécié.

7. Circuit de réglage automatique de fréquence selon la revendication 1, dans lequel lesdits moyens d'arrêt comprennent des moyens de commutation (16, 17), pour commuter la tension de réglage de fréquence envoyée vers l'oscillateur commandé en tension, depuis la tension de balayage à une tension de suivi, lorsqu'un signal de synchronisation de trame est détecté à partir d'un signal reçu.
